# EUROPÄISCHE PATENTSCHRIFT

(11) **EP 3 387 323 B1**
(45) Veröffentlichungstag und Bekanntmachung des Hinweises auf die Patenterteilung: **10.04.2019**
(21) Anmeldenummer: 17706402.9
(22) Anmeldetag: 06.02.2017
(51) Int. Cl.: G02B 26/08, F21S 41/39, F21S 41/675, F21S 45/49, F21S 41/47

(54) **FAHRZEUGSCHEINWERFER UMFASSEND EINE HALTERUNGSVORRICHTUNG FÜR EIN ELEKTRONISCHES BAUTEIL**
VEHICLE HEADLAMP COMPRISING A RETAINING DEVICE FOR AN ELECTRONIC COMPONENT
PROJECTEUR D'UN VÉHICULE COMPORTANT UN DISPOSITIF DE SUPPORT D'UN COMPOSANT ÉLECTRIQUE

(30) Priorität: 24.02.2016 AT 501282016
(43) Veröffentlichungstag der Anmeldung: 17.10.2018
(73) Patentinhaber: ZKW Group GmbH, 3250 Wieselburg (AT)
(72) Erfinder: MAYER, Matthias, 3240 Mank (AT); MITTERLEHNER, Stefan, 3240 Mank (AT)
(74) Vertreter: Patentanwaltskanzlei Matschnig & Forsthuber OG
(86) Internationale Anmeldenummer: PCT/AT2017/060021
(87) Internationale Veröffentlichungsnummer: WO 2017/143372

(56) Entgegenhaltungen:
- EP-A1- 2 327 926
- EP-A2- 1 630 474
- DE-A1-102008 031 262
- DE-A1-102009 049 016
- DE-A1-102011 052 184
- US-A1- 2006 146 502
- US-A1- 2006 176 453

## Beschreibung

Die Erfindung betrifft einen Fahrzeugscheinwerfer mit einem elektronischen Bauteil, umfassend eine Halterungsvorrichtung für das elektronische Bauteil in dem Fahrzeugscheinwerfer, wobei das elektronische Bauteil eine optische Wirkfläche auf einer Vorderseite und eine thermische Wirkfläche sowie elektrische Kontakte auf einer der Vorderseite abgewandten Rückseite umfasst, wobei die Halterungsvorrichtung ferner umfasst: einen Grundkörper mit einer Montageposition für das elektronische Bauteil, sowie einer im Bereich der Montageposition befindlichen Öffnung, durch die ein Zugang zur optischen Wirkfläche des elektronischen Bauteils möglich ist, wobei das elektronische Bauteil mit seiner Vorderseite am Grundkörper aufliegt, eine Leiterplatte, mit der das elektronischen Bauteil über deren elektrische Kontakte verbunden ist, einen Kühlkörper, der an dem Grundkörper befestigt ist.

Bei der Entwicklung der gegenwärtigen Scheinwerfersysteme steht immer mehr der Wunsch im Vordergrund, ein möglichst hochaufgelöstes Lichtbild auf die Fahrbahn projizieren zu können, das rasch geändert und den jeweiligen Verkehrs-, Straßen- und Lichtbedingungen angepasst werden kann. Der Begriff "Fahrbahn" wird hier zur vereinfachten Darstellung verwendet, denn selbstverständlich hängt es von den örtlichen Gegebenheiten ab, ob sich ein Lichtbild tatsächlich auf der Fahrbahn befindet oder auch darüber hinaus erstreckt. Prinzipiell wird das Lichtbild anhand einer Projektion auf eine vertikale Fläche entsprechend der einschlägigen Normen, die sich auf die KFZ-Beleuchtungstechnik beziehen, beschrieben.

Um diesem genannten Bedürfnis zu entsprechen, wurden unter anderem Scheinwerfer entwickelt, in denen eine variabel ansteuerbare Reflektorfläche aus einer Mehrzahl von Mikrospiegeln gebildet ist und eine Lichtemission, die von einer Lichtquelle erzeugt wird, in Abstrahlrichtung des Scheinwerfers reflektiert. Derartige Leuchteinrichtungen sind im Fahrzeugbau wegen ihrer sehr flexiblen Lichtverteilung vorteilhaft, da für unterschiedliche Leuchtbereiche die Beleuchtungsstärke individuell geregelt werden kann und beliebige Lichtverteilungen realisiert werden können, wie beispielsweise eine Abblendlicht-Lichtverteilung, eine Abbiegelicht-Lichtverteilung, eine Stadtlicht-Lichtverteilung, eine Autobahnlicht-Lichtverteilung, eine Kurvenlicht-Lichtverteilung, eine Fernlicht-Lichtverteilung oder die Abbildung von blendfreiem Fernlicht.

Für die Mikrospiegelanordnung kommt die sogenannte Digital Light Processing (DLP®) Projektionstechnik zur Anwendung, bei der Bilder dadurch erzeugt werden, dass ein digitales Bild auf einen Lichtstrahl aufmoduliert wird. Dabei wird durch eine rechteckige Anordnung von beweglichen Mikrospiegeln, auch als Pixel bezeichnet, der Lichtstrahl in Teilbereiche zerlegt und anschließend pixelweise entweder in den Projektionsweg hinein oder aus dem Projektionsweg hinaus reflektiert.

Basis für diese Technik bildet ein elektronisches Bauteil, das die rechteckige Anordnung in Form einer Matrix von Spiegeln und deren Ansteuerungstechnik enthält und als "Digital Micromirror Device" (DMD) bezeichnet wird.

Bei einem DMD-Mikrosystem handelt es sich um einen Flächenlichtmodulator (Spatial Light Modulator, SLM), der aus matrixförmig angeordneten Mikrospiegelaktoren, das heißt verkippbaren spiegelnden Flächen besteht, beispielsweise mit einer Kantenlänge von etwa 16 µm. Die Spiegelflächen sind derart konstruiert, dass sie durch die Einwirkung elektrostatischer Felder beweglich sind. Jeder Mikrospiegel ist im Winkel einzeln verstellbar und weist in der Regel zwei stabile Endzustände auf, zwischen denen innerhalb einer Sekunde bis zu 5000 mal gewechselt werden kann. Die Anzahl der Spiegel entspricht der Auflösung des projizierten Bilds, wobei ein Spiegel ein oder mehrere Pixel darstellen kann. Mittlerweile sind DMD-Chips mit hohen Auflösungen im Megapixel-Bereich erhältlich. Den verstellbaren Einzelspiegeln zugrunde liegende Technologie ist die Micro-Electro-Mechanical-Systems-(MEMS) Technologie.

Während die DMD-Technologie zwei stabile Spiegel-Zustände aufweist, und durch Modulation zwischen beiden stabilen Zuständen der Reflexionsfaktor eingestellt werden kann, weist die "Analog Micromirror Device" (AMD) Technologie die Eigenschaft auf, dass die Einzelspiegel in variablen Spiegelpositionen eingestellt werden können, die dort jeweils in einem stabilen Zustand sind.

Ein typisches Mikrospiegel-Bauteil umfasst ein Gehäuse, auf seiner Vorderseite, hinter einem optischen Sichtfenster, die Matrix von Spiegeln angeordnet ist. Unter der optischen Wirkfläche ("optical interface area") eines solchen Mikrospiegel-Bauteils wird die aktive Spiegelfläche des Bauteils verstanden, das heißt, die Gesamtfläche, die durch alle einzelnen Mikrospiegel gebildet ist. Auf der Rückseite des Gehäuses sind üblicherweise die elektrischen Kontakte in einem Gebiet ("electrical interface area") rings um eine mittig liegende Fläche angeordnet, die zum Anschluss einer Kühleinrichtung vorgesehen ist. Unter der thermischen Wirkfläche ("thermal interface area") eines solchen Mikrospiegel-Bauteils wird die Fläche auf der Rückseite des Bauteils verstanden, die zur Anbringung eines Kühlkörpers vorgesehen ist.

Oft wird das Mikrospiegel-Bauteil in einem sogenannten CLGA- ("Ceramic Land Grid Array") Modul eingebaut, einem Verbindungssystem für integrierte Schaltungen. Beim LGA-System werden die Anschlüsse des integrierten Schaltkreises auf seiner Unterseite in Form eines schachbrettartigen Feldes ("grid array") von Kontaktflächen ("land") ausgeführt. LGA-Prozessoren werden üblicherweise auf Sockel gesetzt, die federnd ausgeführte Kontakte enthalten, was eine geringere mechanische Beanspruchung der Kontakte zur Folge hat. Der keramische Körper des CLGA ist insbesondere für hohe Betriebstemperaturen ausgelegt.

Neben den mechanischen Belastungskräften, die während der Montage der einzelnen Komponenten entstehen können, können im Stand oder während der Fahrt des Fahrzeugs mechanische Belastungskräfte wie Vibrationen oder durch Fahrsituationen Zug- oder Druckkräfte entstehen, die auf sämtliche Komponenten im Fahrzeug wirken. Es besteht daher die Forderung, dass die Komponenten einerseits derart gestaltet sind, dass mechanische Belastungskräfte keinen Einfluss auf deren Funktion bzw. deren Anordnung untereinander haben. Andererseits dürfen die Komponenten hinsichtlich Stabilität oder Lebensdauer nicht beeinträchtigt werden, wie beispielsweise durch hohe Temperaturunterschiede hervorgerufene mechanische Belastungskräfte aufgrund unterschiedlicher Materialausdehnungen benachbarter unterschiedlicher Materialien bei und innerhalb der Komponenten.

DE 10 2009 049 016 A1 offenbart einen gattungsgemäßen Fahrzeugscheinwerfer.

Eine Aufgabe der vorliegenden Erfindung liegt darin, einen Fahrzeugscheinwerfer umfassend eine Halterungsvorrichtung für ein elektronisches Bauteil in dem Fahrzeugscheinwerfer zu schaffen, die die optische Grundfunktion des Fahrzeugscheinwerfers durch das eingesetzte elektronische Bauteil unterstützt, sowie deren stabile, mechanische Befestigung als auch den Anschluss der optischen, elektrischen und thermischen Systemanteile erlaubt. Dabei ist zu berücksichtigen, dass keine mechanischen Belastungskräfte auf die Anschlüsse wirken dürfen. Gleichzeitig soll eine einfache Wartung der Komponenten ermöglicht werden.

Diese Aufgabe wird mit einem Fahrzeugscheinwerfer der eingangs genannten Art dadurch gelöst, dass:
- zumindest ein federnder Abstandshalter (6) zwischen der Leiterplatte (4) und dem Grundkörper (3) angeordnet ist,
- die Leiterplatte eine Öffnung aufweist, durch welche ein Zugang zur thermischen Wirkfläche des elektronischen Bauteils möglich ist, und
- der Kühlkörper auf der thermischen Wirkfläche des elektronischen Bauteils angeordnet ist.

Mit dem Zugang zu einer optischen oder thermischen Wirkfläche ist gemeint, dass die jeweilige Wirkfläche durch eine Öffnung entweder im Grundkörper beziehungsweise in der Leiterplatte erreichbar ist oder das elektronische Bauteil mit der Wirkfläche durch die Öffnung hindurch ragen kann, um die Wirkung der Wirkfläche zu ermöglichen. Die optische Wirkfläche erzeugt ihre Wirkung durch Reflexion von Licht, das einfällt und entsprechend der Steuerung durch das elektronische Bauteil wieder reflektiert wird. Durch die Öffnung ist sichergestellt, dass der Weg des einfallenden und reflektierten Licht nicht beeinträchtigt wird. Die thermische Wirkfläche erzeugt ihre Wirkung durch die Abfuhr von Wärme, die im elektronischen Bauteil auftritt. Zur Verbesserung der Wirkung kann zusätzlich ein Kühlkörper auf der thermischen Wirkfläche angebracht sein. Die Wärme wird zum einen durch die Verlustleistung der Elektronik des elektronischen Bauteils, aber auch durch das auf die optische Wirkfläche eingestrahlte und nicht reflektierte Licht hervorgerufen.

Durch den erfindungsgemäßen Fahrzeugscheinwerfer, umfassend eine Halterungsvorrichtung in dem Fahrzeugscheinwerfer wird erreicht, dass das elektronische Bauteil für die Funktion des Fahrzeugscheinwerfers geeignet montiert ist, zudem geeignet gekühlt werden kann und mechanisch keine Belastungskräfte auf die Leiterplatte wirken, da die Leiterplatte federnd ausgeführt gelagert ist. Zusätzlich ist der Zusammenbau des Fahrzeugscheinwerfers sehr einfach, da beim Zusammensetzen der einzelnen Komponenten bereits jeweils eine Feinjustierung vorgenommen werden kann, um beispielsweise eine Ausrichtung des elektronischen Bauteils auf eine Lichtquelle oder eine Abbildungsoptik zu bewerkstelligen. Durch das Verbindungselement werden alle Komponenten bereits zusammengehalten, aber noch in gewissem Rahmen justierbar.

Die Anordnung stellt sicher, wenn Leiterplatte und Kühlkörper voneinander gesonderte Komponenten sind, dass keine mechanischen Belastungskräfte auf die Leiterplatte wirken, aber dennoch ein direkter Kontakt zwischen Kühlkörper und elektronischem Bauteil zum Wärmetransport gegeben ist.

Die Reduktion der mechanischen Belastungskräfte wird auch dadurch erzielt, indem nur Materialien mit ähnlichen Materialausdehnungskoeffizienten direkt miteinander starr verbunden werden, anderenfalls nur durch federnd ausgeführte Verbindungen verbunden werden.

Wenn die Leiterplatte und der Grundkörper, vorzugsweise mittels einem Verbindungselement, über den federnden Abstandshalter miteinander verbunden und in einem Abstand gehalten sind, ist gewährleistet, dass der federnd ausgeführte Abstandhalter gegen Verrutschen bei der Montage gesichert ist, da dieser beispielsweise als Ring um das Verbindungselement fixiert ist.

Die Verbindungselemente können Schrauben, können aber auch Steckverbindungen, Nieten, geklebte Verbindungen oder dergleichen sein. Schrauben als lösbare und wiederverwendbare Verbindungen sind einfach bei der Wartung der Halterungsvorrichtung, Steckverbindungen haben als feste Verbindungen andererseits Kostenvorteile.

Ist zwischen der Leiterplatte und dem Kühlkörper zumindest ein zweiter federnd ausgeführter Abstandshalter angeordnet, so ist die Leiterplatte zwischen zwei federnd ausgeführten Abstandshaltern fixiert und sehr gut gegen Vibrationen des Scheinwerfers gedämpft.

Durch Verwendung eines Analogen oder Digitalen Mikrospiegel-Arrays als elektronisches Bauteil ergibt sich eine besonders vorteilhafte Ausgestaltung der optischen Funktion des Fahrzeugscheinwerfers.

In der erfindungsgemäßen Halterungsvorrichtung ermöglicht die genannte Öffnung im Grundkörper den Zugang zur optischen Wirkfläche des elektronischen Bauteils, d.h. die Matrix von Spiegeln im Bauteil wird für die weiteren Komponenten der Beleuchtungseinrichtung sichtbar und das von einer Lichtquelle eingestrahlte Licht kann durch die Öffnung ein- und austreten und über die optische Wirkfläche reflektiert werden.

Die Leiterplatte umfasst ebenfalls eine Öffnung, durch die ein Kühlkörper durchgestreckt werden kann und Zugang zur thermischen Wirkfläche des elektronischen Bauteils ermöglicht, um dort einen Kühlkörper anzubringen.

Die Erfindung und weitere Vorteile werden in Folgenden anhand von nicht einschränkenden Ausführungsbeispielen näher beschrieben, die in den beiliegenden Zeichnungen veranschaulicht sind. Die Zeichnungen zeigen:
- Fig. 1: eine Ansicht auf eine Chip-Oberseite eines elektronischen Bauteils gemäß einem Ausführungsbeispiel der Erfindung in Form eines DLP-Chips,
- Fig. 2: eine Ansicht auf eine Chip-Unterseite des elektronischen Bauteils,
- Fig. 3: eine perspektivische Ansicht von einer ersten Seite eines Ausführungsbeispiels eines Fahrzeugscheinwerfers mit einer Halterungsvorrichtung nach der Erfindung,
- Fig. 4: eine Explosionsansicht des Scheinwerfers von der ersten Seite,
- Fig. 5: eine Explosionsansicht von wichtigen Komponenten der Halterungsvorrichtung des Scheinwerfers von einer zweiten Seite,
- Fig. 6: eine Ansicht von unten auf den Scheinwerfer mit der Lage von den Schnittebenen A-A und B-B,
- Fig. 7: den Scheinwerfer in einer Schnittansicht gemäß der Schnittebene A-A der Fig. 6,
- Fig. 8: den Scheinwerfer in einer Schnittansicht gemäß der Schnittebene B-B der Fig. 6.

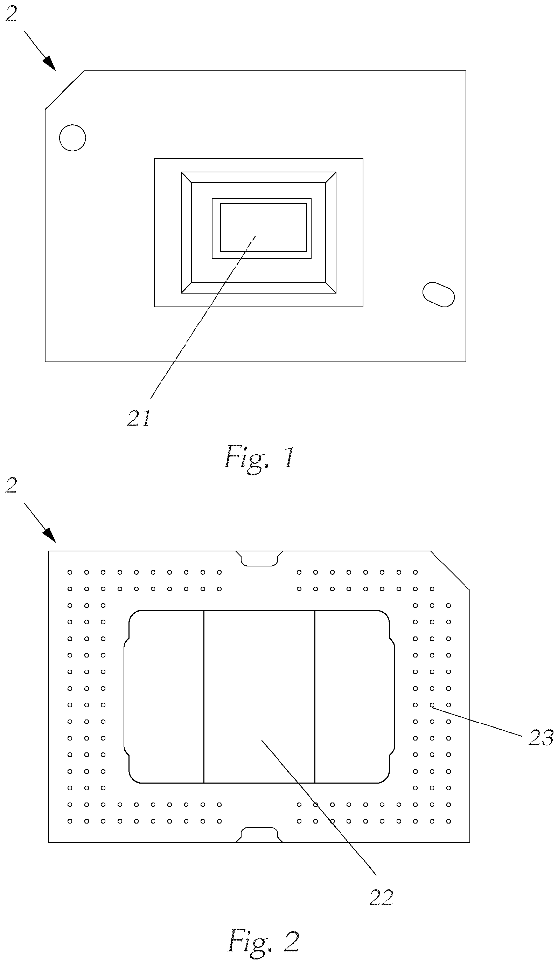

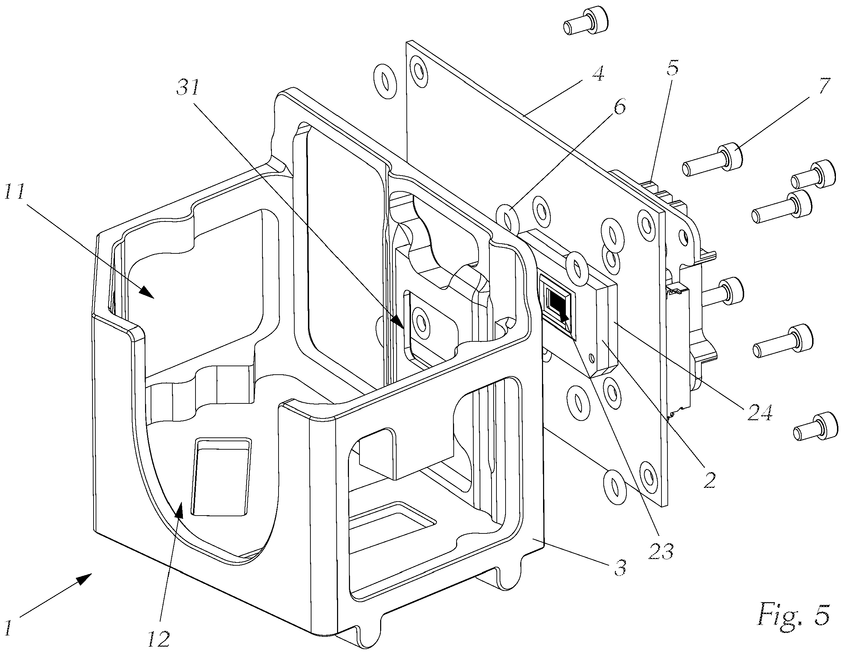

Unter Bezugnahme auf **Fig. 1** bis **Fig. 8** werden nun Ausführungsbeispiele der Erfindung näher erläutert. Insbesondere sind in einem Scheinwerfer wichtige Teile dargestellt, wobei klar ist, dass ein Scheinwerfer noch viele andere, nicht gezeigte Teile enthält, die einen sinnvollen Einsatz in einem Kraftfahrzeug, wie insbesondere einem PKW oder Motorrad, ermöglichen.

In den Figuren sind die Komponenten einer Halterungsvorrichtung 1 für ein elektronisches Bauteil 2 in einem Fahrzeugscheinwerfer im Überblick bzw. in verschiedenen Perspektiven und Schnitten dargestellt. In den Figuren ist nur ein stellvertretendes Bezugszeichen für eine jeweilige Komponente eingezeichnet, auch wenn dieselbe Komponente mehrfach ausgeführt ist.

**Fig. 1** und **Fig. 2** zeigen gemäß der Erfindung ein elektronisches Bauteil 2 in Form eines Digitalen Mikrospiegel-Arrays (DLP®-Chip). Das elektronische Bauteil 2 weist eine optische Wirkfläche 21 (Mikrospiegel-Array) auf einer Vorderseite und eine thermische Wirkfläche 22 sowie rings angeordnete elektrische Kontakte 23 auf einer der Vorderseite abgewandten Rückseite auf. Ferner sind Justierlöcher erkennbar. In diesem Beispiel ist das elektronische Bauteil 2 ein Analoges oder Digitales Mikrospiegel-Array.

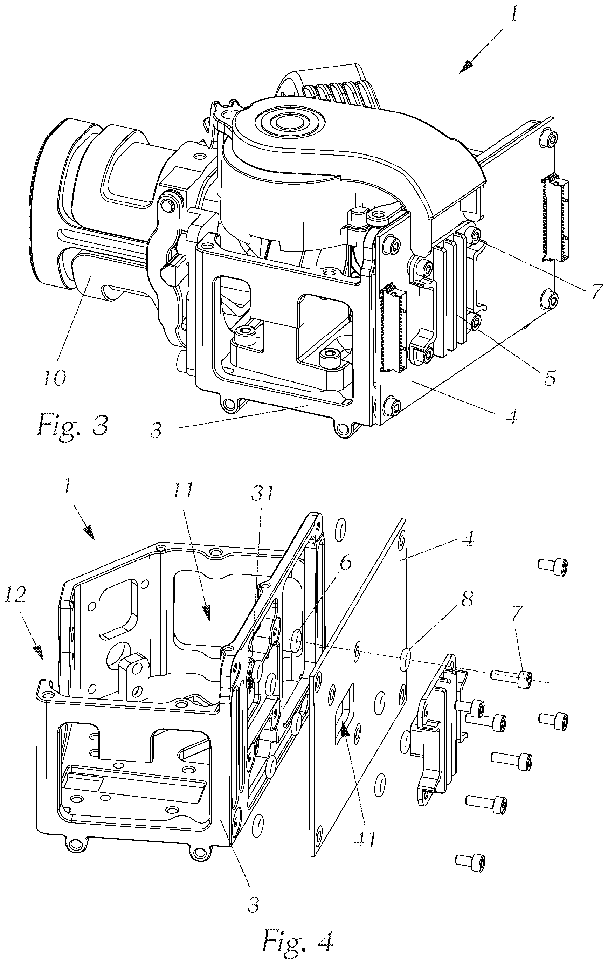

Die Chip-Oberseite beziehungsweise die Chip-Unterseite in Fig. 1 und Fig. 2 entspricht nicht den Ansichten der gesamten Halterungsvorrichtung gemäß den Fig. 3 bis Fig. 8.

In **Fig. 3** bis **Fig. 5** ist der Aufbau der Halterungsvorrichtung 1 gemäß einem Ausführungsbeispiel dargestellt.

Das elektronische Bauteil 2 ist auf einem Grundkörper 3 montiert, und zwar in einer hierfür vorgesehenen Montageposition. Der Grundkörper 3 hat im Bereich der Montageposition eine Öffnung 31, durch die ein Zugang zur optischen Wirkfläche 21 des elektronischen Bauteils 2 möglich ist. Der Zugang kann beispielsweise derart ausgeführt sein, dass das elektronische Bauteils 2 durch die Öffnung 31 durchragt. Dadurch wird die Matrix von Spiegeln im elektronischen Bauteil 2 für weitere Komponenten der Beleuchtungseinrichtung optisch zugänglich beziehungsweise sichtbar, was ermöglicht, dass das von einer Lichtquelle eingestrahlte Licht über die optische Wirkfläche in Abstrahlrichtung des Scheinwerfers reflektiert werden kann. Zusätzlich liegt das elektronische Bauteil 2 mit seiner Vorderseite am Grundkörper 3 auf.

Eine Leiterplatte 4, mit der das elektronische Bauteil 2 über deren elektrische Kontakte verbindbar ist, weist eine Öffnung 41 auf, durch welche ein Zugang zur thermischen Wirkfläche 22 des elektronischen Bauteils 2 möglich ist.

Ein Kühlkörper 5 ist auf der thermischen Wirkfläche 22 des elektronischen Bauteils 2 angeordnet und kann am Grundkörper befestigt werden.

Mehrere federnd ausgeführte Abstandshalter 6 sind zwischen der Leiterplatte 4 und dem Grundkörper 3 angeordnet. Die Abstandshalter 6 können ringförmig ausgeführt sein, insbesondere Torus-förmig oder hohlzylindrisch. Mehrere Verbindungselemente 7 legen den Kühlkörper 5 am Grundkörper 3 fest. Die Verbindungselemente 7 sind in diesem Beispiel Schrauben, können aber auch Steckverbindungen, Nieten, geklebte Verbindungen oder dergleichen sein. Sie verbinden zusätzlich die Leiterplatte 4 mit dem Grundkörper 3 über federnd ausgeführte Abstandshalter 6 elastisch. Zusätzlich sind zwischen der Leiterplatte 4 und dem Kühlkörper 5 zweite federnd ausgeführte Abstandshalter 8 angeordnet.
Das elektronische Bauteil 2 liegt mit seiner Vorderseite am Grundkörper 3 auf und wird mit den Verbindungselementen 7 und dem Kühlkörper 5 fixiert. Bei Verwendung einer Schraube als Verbindungselement 7 kann im Grundkörper 3 ein Gewinde vorgesehen sein. Mit anderen Worten ist das elektronische Bauteil 2 zwischen dem Grundkörper 3 und dem Kühlkörper 5 eingespannt, wobei über die Verbindungselemente 7 die Spannkraft aufgebracht und die Verbindung hergestellt ist.

An der Halterungsvorrichtung 1 kann ein Projektionsoptik-Modul 10 befestigt werden, das eine Projektionsoptik zur Strahlformung umfasst. Ferner ist an der Halterungsvorrichtung 1 eine Lichtquellen-Öffnung 11 sowie eine Projektionsoptik-Öffnung 12 vorgesehen, um eine Lichtquelle und eine Projektionsoptik eines Fahrzeugscheinwerfers in eine optische Anordnung gemeinsam mit dem elektronischen Bauteil 2 zu bringen. Die Projektionsoptik des Fahrzeugscheinwerfers kann in dem dazu vorgesehenen Projektionsoptik-Modul 10 an der Halterungsvorrichtung 1 befestigt werden. Das von der Lichtquelle in einem Lichtquellen-Modul 9 erzeugte Licht wird in Richtung des elektronischen Bauteils 2 gestrahlt, um an der optischen Wirkfläche 21 in Richtung der Projektionsoptik reflektiert zu werden.

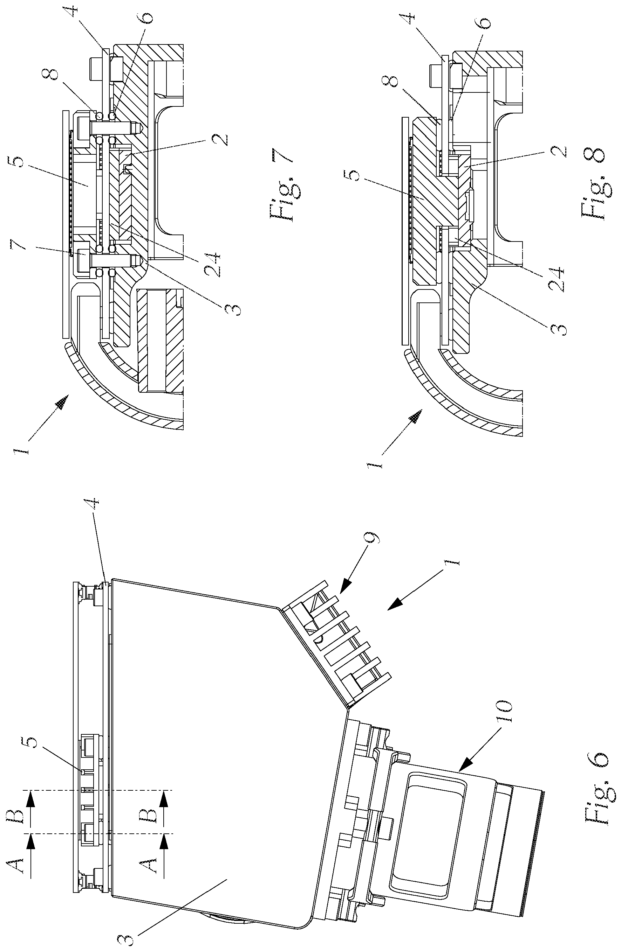

**Fig. 6** zeigt die Halterungsvorrichtung 1 mit dem Grundkörper 3 und der Leiterplatte 4 sowie dem Kühlkörper 5 in einer Ansicht von unten mit der Lage von Schnittebenen A-A und B-B. Die Schnittebene A-A verläuft durch die Verbindungselemente 7, die Schnittebene B-B durch den Kühlkörper 5.

**Fig. 7** zeigt einen Querschnitt der Halterungsvorrichtung 1 in einer Schnittebene A-A der Fig. 6, wobei die Schnittebene A-A durch die Verbindungselemente 7 verläuft. Auf der Leiterplatte 4 ist auf einem Montagesockel 24 das elektronische Bauteil 2 montiert. Die Leiterplatte 4 und der Kühlkörper 5 sind am Grundkörper 3 durch die Verbindungselemente 7 und die federnden Abstandshalter 6 und 8 in definiertem Abstand gehalten. Auf der Rückseite des elektronischen Bauteils 2 ist der Kühlkörper 5 angeordnet.

**Fig. 8** zeigt einen Querschnitt der Halterungsvorrichtung 1 in einer Schnittebene B-B der Fig. 6, wobei die Schnittebene B-B durch den Kühlkörper 5 verläuft. Der Kühlkörper 5 ist am Grundkörper 3 durch die Verbindungselemente festgemacht. Es ist erkennbar, wie der Kühlkörper 5 auf dem elektronischen Bauteil 2 angeordnet ist, wobei der Kühlkörper 5 durch den Montagesockel 24 durchgesteckt ist. Die federnden Abstandshalter 6 und 8 fixieren die Leiterplatte 4 erfindungsgemäß derart, dass keine mechanischen Belastungskräfte auf sie wirken.

Folgende Bezugszeichen werden im Weiteren verwendet:
- 1: Halterungsvorrichtung
- 2: Elektronisches Bauteil
- 21: Optische Wirkfläche des elektronischen Bauteils
- 22: Thermische Wirkfläche des elektronischen Bauteils
- 23: Elektrische Kontakte des elektronischen Bauteils
- 24: Montagesockel für das elektronische Bauteil
- 3: Grundkörper
- 31: Öffnung für elektronisches Bauteil im Grundkörper
- 4: Leiterplatte
- 41: Öffnung für elektronisches Bauteil in Platine
- 5: Kühlkörper
- 6: Erster federnder Abstandshalter
- 7: Verbindungselement
- 8: Zweiter federnder Abstandshalter
- 9: Lichtquellen-Modul
- 10: Projektionsoptik-Modul
- 11: Lichtquellen-Öffnung
- 12: Projektionsoptik-Öffnung

## Patentansprüche

1. Fahrzeugscheinwerfer mit einem elektronischen Bauteil (2), umfassend eine Halterungsvorrichtung (1) für das elektronische Bauteil (2) in dem Fahrzeugscheinwerfer, wobei das elektronische Bauteil (2) eine optische Wirkfläche (21) auf einer Vorderseite und eine thermische Wirkfläche (22) sowie elektrische Kontakte (23) auf einer der Vorderseite abgewandten Rückseite umfasst, wobei die Halterungsvorrichtung (1) ferner umfasst:
- einen Grundkörper (3) mit einer Montageposition für das elektronische Bauteil, sowie einer im Bereich der Montageposition befindlichen Öffnung (31), durch die ein Zugang zur optischen Wirkfläche (21) des elektronischen Bauteils (2) möglich ist, wobei das elektronische Bauteil (2) mit seiner Vorderseite am Grundkörper (3) aufliegt,
- eine Leiterplatte (4), mit der das elektronischen Bauteil (2) über deren elektrische Kontakte verbunden ist,
- einen Kühlkörper (5), der an dem Grundkörper befestigt ist,
**dadurch gekennzeichnet, dass**:
- zumindest ein federnder Abstandshalter (6) zwischen der Leiterplatte (4) und dem Grundkörper (3) angeordnet ist,
- die Leiterplatte (4) eine Öffnung (41) aufweist, durch welche ein Zugang zur thermischen Wirkfläche (22) des elektronischen Bauteils (2) möglich ist, und
- der Kühlkörper (5) auf der thermischen Wirkfläche (22) des elektronischen Bauteils (2) angeordnet ist.

2. Fahrzeugscheinwerfer nach Anspruch 1, **dadurch gekennzeichnet, dass** die Leiterplatte (4) und der Grundkörper (3), vorzugsweise mittels eines Verbindungselements (7), insbesondere einer Schraube oder Steckverbindung, über den federnden Abstandshalter (6) miteinander verbunden und in einem Abstand gehalten sind.

3. Fahrzeugscheinwerfer nach Anspruch 1 oder 2, **dadurch gekennzeichnet, dass** zwischen Leiterplatte (4) und Kühlkörper (5) zumindest ein zweiter federnder Abstandshalter (8) angeordnet ist.

4. Fahrzeugscheinwerfer nach einem der Ansprüche 1 bis 3, **dadurch gekennzeichnet, dass** das elektronische Bauteil (2) ein Analoges oder Digitales Mikrospiegel-Array ist.

## Claims

1. A vehicle headlamp having an electronic component (2), comprising a mounting device (1) for the electronic component (2) in the vehicle headlamp, wherein the electronic component (2) comprises an optical effective area (21) on a front side and a thermal effective area (22) and also electrical contacts (23) on a rear side facing away from the front side,
the mounting device (1) further comprising:
- a main body (3) with a mounting position for the electronic component, and an opening (31), located in the region of the mounting position, through which access to the optical effective area (21) of the electronic component (2) is possible, wherein the electronic component (2) rests with its front side on the main body (3),
- a printed circuit board (4), to which the electronic component (2) is connectable via electrical contacts thereof,
- a heat sink (5), which is fastened to the main body, **characterised in that**:
- at least one resilient spacer (6) is arranged between the printed circuit board (4) and the main body (3),
- the printed circuit body (4) has an opening (41), through which access to the thermal effective area (22) of the electronic component (2) is possible, and
- the heat sink (5) is arranged on the thermal effective area (22) of the electronic component (2) .

2. The vehicle headlamp according to claim 1, **characterised in that** the printed circuit board (4) and the main body (3) are connected to one another via the resilient spacer (6) preferably by means of a connection element (7), in particular a screw or plug connection, and are held at a distance from one another.

3. The vehicle headlamp according to claim 1 or 2, **characterised in that** at least one second resilient spacer (8) is arranged between the printed circuit board (4) and heat sink (5).

4. The vehicle headlamp according to any one of claims 1 to 3, **characterised in that** the electronic component (2) is an analogue or digital micromirror array.

## Revendications

1. Phare de véhicule comprenant un composant électronique (2), comportant un dispositif de retenue (1) pour le composant électronique (2) dans le phare de véhicule, le composant électronique (2) comportant une surface active optiquement (21) sur un côté avant et une surface active thermiquement (22) ainsi que des contacts électriques (23) sur un côté arrière opposé au côté avant,
le dispositif de retenue (1) comportant en outre :
- un corps de base (3) ayant une position de montage pour le composant électronique, ainsi qu'une ouverture (31) se trouvant dans la zone de la position de montage, à travers laquelle un accès à la surface active optiquement (21) du composant électronique (2) est possible, le composant électronique (2) s'appliquant avec son côté avant sur le corps de base (3) ;
- une carte de circuits imprimés (4), avec laquelle le composant électronique (2) est connecté par l'intermédiaire de ses contacts électriques ;
- un dissipateur thermique (5), qui est fixé sur le corps de base ;
**caractérisé par le fait que** :
- au moins un espaceur élastique (6) est disposé entre la carte de circuits imprimés (4) et le corps de base (3) ;
- la carte de circuits imprimés (4) présente une ouverture (41), à travers laquelle un accès à la surface active thermiquement (22) du composant électronique (2) est possible ; et
- le dissipateur thermique (5) est disposé sur la surface active thermiquement (22) du composant électronique (2).

2. Phare de véhicule selon la revendication 1, **caractérisé par le fait que** la carte de circuits imprimés (4) et le corps de base (3) sont reliés l'un à l'autre et maintenus à distance par l'intermédiaire de l'espaceur élastique (6), de préférence au moyen d'un élément de liaison (7), en particulier d'une vis ou d'une liaison enfichable.

3. Phare de véhicule selon l'une des revendications 1 ou 2, **caractérisé par le fait qu'**au moins un second espaceur élastique (8) est disposé entre la carte de circuits imprimés (4) et le dissipateur thermique (5).

4. Phare de véhicule selon l'une des revendications 1 à 3, **caractérisé par le fait que** le composant électronique (2) est un matrice de micro-miroirs analogiques ou numériques.
